# EUROPÄISCHE PATENTSCHRIFT

(11) **EP 2 572 244 B1**
(45) Veröffentlichungstag und Bekanntmachung des Hinweises auf die Patenterteilung: **17.09.2014**
(21) Anmeldenummer: 11721286.0
(22) Anmeldetag: 16.05.2011
(51) Int. Cl.: G03F 7/30, G03F 7/24

(54) **VORRICHTUNG UND VERFAHREN ZUM HERSTELLEN VON FLEXODRUCKSLEEVES**
DEVICE AND METHOD FOR PRODUCING FLEXOGRAPHIC PRINTING SLEEVES
DISPOSITIF ET PROCÉDÉ POUR FABRIQUER DES MANCHONS POUR IMPRESSION FLEXOGRAPHIQUE

(30) Priorität: 17.05.2010 DE 102010029018
(43) Veröffentlichungstag der Anmeldung: 27.03.2013
(73) Patentinhaber: Flint Group Germany GmbH, 70469 Stuttgart (DE)
(72) Erfinder: DIETZ, Gernot, 67304 Eisenberg (DE)
(74) Vertreter: Schuck, Alexander
(86) Internationale Anmeldenummer: PCT/EP2011/057833
(87) Internationale Veröffentlichungsnummer: WO 2011/144553

(56) Entgegenhaltungen:
- US-A- 4 108 683
- US-A- 5 919 378

## Beschreibung

Die vorliegende Erfindung betrifft eine Vorrichtung zum Herstellen von Flexodrucksleeves ausgehend von fotopolymersierbaren Sleeves umfassend mindestens eine Auswascheinheit, eine Trockeneinheit sowie eine Nachbelichtungseinheit, wobei die Flexodrucksleeves innerhalb der Apparatur mit einer Transporteinrichtung transportiert werden, und die Sleeves in der Transporteinrichtung doppelt translatorisch in Längsrichtung gelagert sind. Die Erfindung betrifft weiterhin ein Verfahren zum Herstellen von Flexodrucksleeves unter Verwendung dieser Apparatur.

Die Herstellung von druckfertigen Flexodruckformen ist ein mehrstufiger Prozess. Als Ausgangsmaterial werden fotopolymerisierbare Flexodruckelemente eingesetzt, bei denen eine fotopolymerisierbare, elastomere Schicht auf einem geeigneten Träger aufgebracht ist. Bei dem Träger kann es sich um Polymer- oder Metallfolien handeln oder aber um zylindrische Hülsen, beispielsweise aus polymeren Materialien oder Metallen. Zylindrische Hülsen, auf der eine fotopolymerisierbare Schicht bzw. eine Druckschicht aufgebracht ist, werden auch Sleeves genannt.

In einem ersten Schritt wird die fotopolymerisierbare Schicht entsprechend dem gewünschten Druckmotiv durch eine geeignete Maske hindurch bildmäßig mit aktinischem Licht belichtet. Die Maske weist für aktinisches Licht undurchlässige Bereiche und für aktinisches Licht durchlässige Bereiche auf. Beim Belichten polymerisiert die fotopolymerisierbare Schicht in den belichteten Bereichen, während sie in den unbelichteten Bereichen nicht polymerisiert. Bei der Maske kann es sich beispielsweise um ein fotografisches Negativ handeln, welches auf die fotopolymerisierbare Schicht aufgelegt wird, oder um eine auf der fotopolymerisierbaren Schicht aufgebrachte, digital bebilderbare Schicht, beispielsweise eine laserablatierbare opake Schicht, in die mittels eines Lasers eine Maske eingeschrieben wird. Bei der digital bebilderbaren Schicht kann es sich weiterhin um eine auf der fotopolymerisierbaren Schicht ausgebrachte Schicht handeln, die bildmäßig für UV-Licht opak gemacht werden kann, beispielsweise eine mit einem Inkjet-Drucker beschreibbare Schicht oder eine strahlungsempfindliche Schicht, die mit Hilfe einer Strahlungsquelle in bestimmten Bereichen geschwärzt werden kann.

Nach dem bildmäßigen Belichten werden die unbelichteten Bereiche der Schicht unter Verwendung geeigneter Lösemittel entfernt und die Druckform zur Entfernung von Lösemittelresten getrocknet. Hieran kann sich noch eine Nachbehandlung anschließen, beispielsweise eine Belichtung mit UV-A- und/oder UV-C-Licht.

Die geschilderten Schritte werden jeweils in geeigneten Verarbeitungsgeräten durchgeführt. Um eine möglichst schnelle und wirtschaftliche Herstellung von Druckformen zu gewährleisten, sind auch Verarbeitungsgeräte bekannt, in denen zwei oder mehrere der genannten Verarbeitungsschritte automatisch nacheinander durchgeführt werden.

Der Nachteil der bekannten Verarbeitungsgeräte ist der vergleichsweise hohe Platzbedarf. Sie können typischerweise 8 bis 13 m lang sein. Weiterhin besteht aus wirtschaftlichen Gründen nach wie vor Bedarf, die Verarbeitungszeiten so weit wie möglich zu verkürzen.

US 5,919,378 offenbart eine Vorrichtung zum Herstellen von Runddruckformen. Hierbei werden bildmäßig belichtete Sleeves in ein Vorratsmagazin eingelegt und über eine Lösemitteldampfschutzschleuse in eine Auswaschvorrichtung weiter transportiert. Von dort werden die Sleeves über eine Inspektionseinheit, der Sleeves zu Prüfzwecken entnommen werden können in eine Trockeneinheit sowie optional eine Nachbehandlungseinheit zur Belichtung mit UV-C-Licht und schließlich in ein Ausgabemagazin transferiert.

US 5,919,378 offenbart weiterhin ein Verfahren zum Herstellen von Runddruckformen, welches die folgenden Verfahrensschritte -in der genannten Reihenfolge- umfasst: Absaugen von Lösemitteldämpfen, Auswaschen, Trockenen sowie Nachbehandlung mit UVA- und UVC-Strahlung, wobei die Runddruckform zwischen den Schritten jeweils transportiert wird. Auch bei diesem Gerät sowie dem genannten Verfahren ist der Platzbedarf durch das Vorhandensein einer separaten Lösemitteldampfschutzschleuse sowie der Absaugung von Lösemitteldämpfen bereits vor dem eigentlichen Auswaschschritt relativ hoch. Durch die relativ große Verfahrenslänge beim Vorhandensein einer Lösemitteldampfschutzschleuse wird zudem die Prozesszeit für die Herstellung eines druckfertigen Sleeves verlängert, wodurch sich die Produktionskapazität verringert.

Aufgabe der Erfindung ist es daher, eine Vorrichtung zur Herstellung von Sleeves bereit zu stellen, welche möglichst kompakt gebaut ist und die eine schnelle und zuverlässige Herstellung von Sleeves ermöglicht.

Dementsprechend wird eine Vorrichtung zum Herstellen von Flexodrucksleeves bereitgestellt, welche mindestens
(II) eine Auswascheinheit zum Entfernen unbelichteter Anteile bildmäßig belichteter Sleeves mithilfe von Auswaschmitteln,
(III) eine Trockeneinheit zum Entfernen von Resten der Auswaschmittel aus den ausgewaschenen Sleeves, sowie
(IV) eine Nachbelichtungseinheit zum Nachbelichten der Sleeves mit UV-Strahlung umfasst,
   und wobei die Einheiten (II), (III) und (IV) in der genannten Reihenfolge unmittelbar hintereinander angeordnet sind, die Sleeves eine Länge L aufweisen und zur Verarbeitung in der Vorrichtung mithilfe geeigneter Haltevorrichtungen konzentrisch auf Achsen der Länge I gelagert sind, so dass die Sleeves während der Verarbeitung rotieren können, mit der Maßgabe, dass I > L ist, und wobei weiterhin die Einheiten (II) und (IV) jeweils eine Transportvorrichtung (T) aufweisen, mit denen die Sleeves in die Einheit hinein und von dort aus zur jeweils nächsten Einheit bzw. aus der Vorrichtung heraus transportiert werden können, und wobei
   - die Transportvorrichtung (T) zwei parallel zueinander angeordnete Halterungen (H) in einem Abstand A zum Aufnehmen der beidseits der Sleeves überstehenden Achsen der auf Achsen montierten Sleeves aufweist, wobei für A die folgende Beziehung L < A ≤ I gilt, und
   - wobei die Halterungen (H) doppelt translatorisch in Längsrichtung der Vorrichtung gelagert sind.

In einer bevorzugten Ausführungsform der Erfindung umfasst die Transportvorrichtung (T) jeweils zwei parallel zueinander angeordnete Transportarme, wobei die Transportarme so gelagert sind, dass sie in Längsrichtung verschiebbar sind, und auf jedem der Transportarme eine längs der Transportarme verschiebbare Halterung (H) angeordnet ist.

Weiterhin wurde ein Verfahren zum Herstellen von Flexodrucksleeves unter Verwendung einer derartigen Apparatur gefunden.

### Verzeichnis der Figuren:

- Figur 1:: Schematische Darstellung der Montage eines Sleeves auf einer Achse
- Figur 2:: Schematische Darstellung der Lagerung eines Sleeves in der verschiebbaren Halterung (H)
- Figur 3:: Sicht von oben auf einen auf der Transportvorrichtung gelagerten Sleeve
- Figur 4:: Schematische Darstellung des Transports eines Sleeves mit der erfindungsgemäßen Transportvorrichtung, Übernahme eines Sleeves
- Figur 5:: Schematische Darstellung des Transports eines Sleeves mit der erfindungsgemäßen Transportvorrichtung, Weitergabe eines Sleeves
- Figur 6:: Beispielhafte Darstellung einer Ausführungsform der erfindungsgemäßen Vorrichtung umfassend eine Auswascheinheit (II), eine Trockeneinheit (III) und eine Nachbelichtungseinheit (IV)
- Figur 7:: Beispielhafte Darstellung einer Ausführungsform der erfindungsgemäßen Vorrichtung umfassend eine Belichtungseinheit (I), eine Auswascheinheit (II), eine Trockeneinheit (III) und eine Nachbelichtungseinheit (IV)
- Figur 8:: Schematische Darstellung einer bevorzugten Ausführungsform (IIa) der Auswascheinheit
- Figur 9:: Schematische Darstellung einer bevorzugten Auswascheinheit (IIa) mit Lösemittelaufgabe und Rakeln
- Figur 10:: Schematische Darstellung des Sleevetransports von der Sleeveeingabe in die Auswascheinheit (II)
- Figur 11:: Schematische Darstellung des Sleevetransports von der Auswascheinheit (II) in die Trockeneinheit (III)

Zu der Erfindung ist im Einzelnen das Folgende auszuführen:

### Eingesetzte Sleeves

Unter dem Begriff "Flexodrucksleeve" im Sinne dieser Erfindung ist eine druckfertige Runddruckform zu verstehen, bei der auf einer zylindrischen Hülse eine elastomere Reliefschicht aufgebracht ist.

Der Begriff "fotopolymerisierbarer Sleeve" bezeichnet das zur Herstellung von Flexodrucksleeves verwendete Ausgangsmaterial, nämlich eine dimensionsstabile zylindrische Hülse, auf der eine fotopolymerisierbare Schicht aufgebracht ist. Es kann sich hierbei um Hülsen handeln, welche vollständig mit einer fotopolymerisierbaren Schicht bedeckt sind, sogenannte Endlos-nahtlos-Sleeves, oder aber um Hülsen, auf die auf geeignete Art und Weise fotopolymerisierbare Flexodruckplatten aufgebracht sind (die sogenannte plate-on-Sleeve-Technologie), beispielsweise mithilfe einer Haftschicht wie beispielsweise doppelseitigem Klebeband oder einer Klemmleiste.

Bei den für Flexodrucksleeves üblicherweise verwendeten Hülsen handelt es sich um zylindrische Hohlkörper unterschiedlichen Aufbaus und unterschiedlicher Zusammensetzung, wobei Aufbau und Zusammensetzung vom Fachmann gemäß den Anforderungen im Druck ausgewählt werden. Es kann sich bei den Hülsen beispielsweise um metallische, polymere oder faserverstärkte polymere zylindrische Hohlkörper handeln, aber auch um komplexere Hohlkörper bestehend aus mehreren Schichten wie zum Beispiel einer relativ harten, beständigen oberen Schicht, einer kompressiblen Zwischenschicht und einer harten, dimensionsstabilen inneren Schicht. Bei relativ leicht axial verformbaren Hülsen geringer Wandstärke, z.B. bei sog. Dünnhülsen, kann weiterhin zur Erhöhung der Stabilität während der Verarbeitung eine zusätzliche Adapterhülse verwendet werden, auf welche die eigentliche Trägerhülse für die Dauer des Verarbeitungsprozesses reversibel aufgezogen wird.

Bei der fotopolymerisierbaren Schicht kann es sich um Schichten aus beliebigen fotopolymerisierbaren Zusammensetzungen handeln, welche zur Herstellung von Flexodruckformen geeignet sind. Die fotopolymerisierbaren Schichten umfassen in der Regel elastomere Bindemittel, beispielsweise Styrol-Butadien- oder Styrol-Isopren-Blockcopolymere, ethylenisch ungesättigte Monomere, Fotoinitiatoren sowie optional weitere Hilfsstoffe wie Weichmacher, Farbstoffe oder Stabilisatoren. Geeignete Zusammensetzungen fotopolymerisierbarer Schichten zur Herstellung von Flexodruckformen sind dem Fachmann bekannt, und er trifft je nach den gewünschten Eigenschaften der Flexodruckform eine geeignete Auswahl. Durch die Zusammensetzung lässt sich beispielsweise die Härte der Reliefschicht bestimmen. Fotopolymerisierbare Sleeves können darüber noch weitere Schichten aufweisen, beispielsweise eine zweite fotopolymeriserbare Schicht anderer Zusammensetzung (eine sogenannte Oberschicht), entklebende Schichten auf der fotopolymerisierbaren Schicht, häufig auch als "Substratschicht" bezeichnet, oder digital bebilderbare Schichten wie beispielsweise laserablatierbare Schichten.

### Montage der Sleeves

Mithilfe der erfindungsgemäßen Apparatur können Sleeves unterschiedlicher Länge und unterschiedlichen Durchmessers verarbeitet werden. Zur Verarbeitung in der Apparatur werden die Sleeves auf Achsen mithilfe geeigneter Halteelemente befestigt. Die Achsen werden in der Apparatur in geeigneten Haltevorrichtungen drehbar gelagert und ermöglichen somit, dass die Sleeves während der Verarbeitung in der Apparatur in Drehung gehalten werden können. Die Achsen weisen dabei unabhängig von der Länge der Sleeves immer die gleiche Länge I auf, wobei die Länge der Sleeves L naturgemäß geringer sein muss als die der Achsen, d.h. des gilt L < I. Die Position der Haltelemente auf der Achse ist veränderbar, so dass mit dem Gerät auch Sleeves unterschiedlicher Länge verarbeitet werden können.

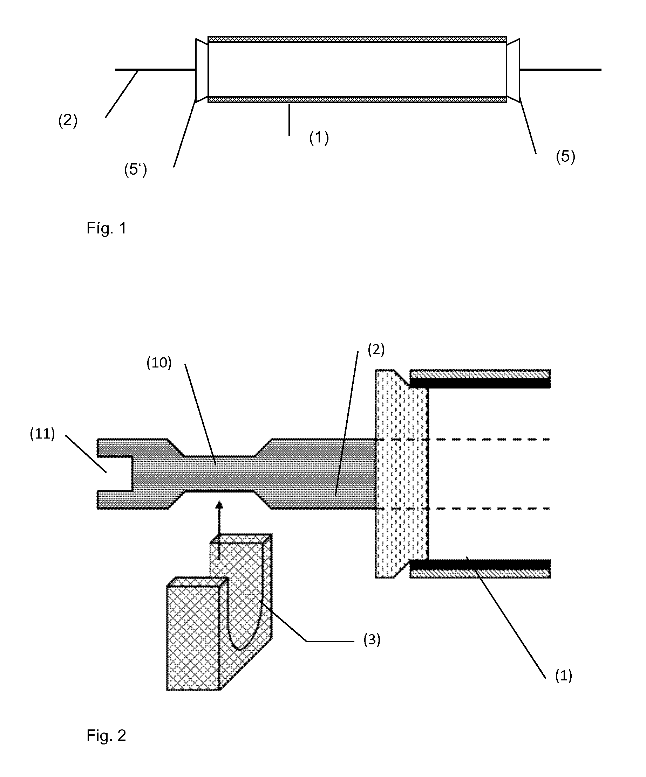

Halteelemente, mit denen Sleeves auf Achsen gehalten werden können, sind dem Fachmann prinzipiell bekannt. Die beiden Halteelemente können beispielsweise jeweils ungefähr die Form eines Kegelstumpfs oder einer zylindrischen Scheibe aufweisen. Mithilfe der Halteelemente lässt sich der Sleeve auf der Achse festklemmen. Mit derartigen Kegelstümpfen oder Scheiben lassen sich auch Sleeves mit unterschiedlichem Durchmesser auf den Achsen befestigen. Figur 1 zeigt exemplarisch eine mögliche Ausführungsform der Erfindung, bei der ein Sleeve (1) mithilfe von zwei Halteelementen (5), (5') auf eine Achse (2) montiert ist. Die Achse steht beidseitig des Sleeve jeweils aus dem Sleeve heraus, so dass der Sleeve mit den überstehenden Abschnitten der Achse in die Schlitten der Transportvorrichtung (T) eingelegt werden kann. Die Länge I richtet sich nach der Baubreite des Geräts und kann beispielsweise 2000 mm bis 2500 mm betragen. Die Achsen sollten beidseits des Sleeves in der Regel jeweils mindestens 50 mm, bevorzugt mindestens 100 mm aus den Sleeves herausragen. Sie können beispielsweise 100 mm bis 300 mm, bevorzugt 150 mm bis 250 mm und beispielsweise etwa 200 mm herausragen.

### Erfindungsgemäße Vorrichtung

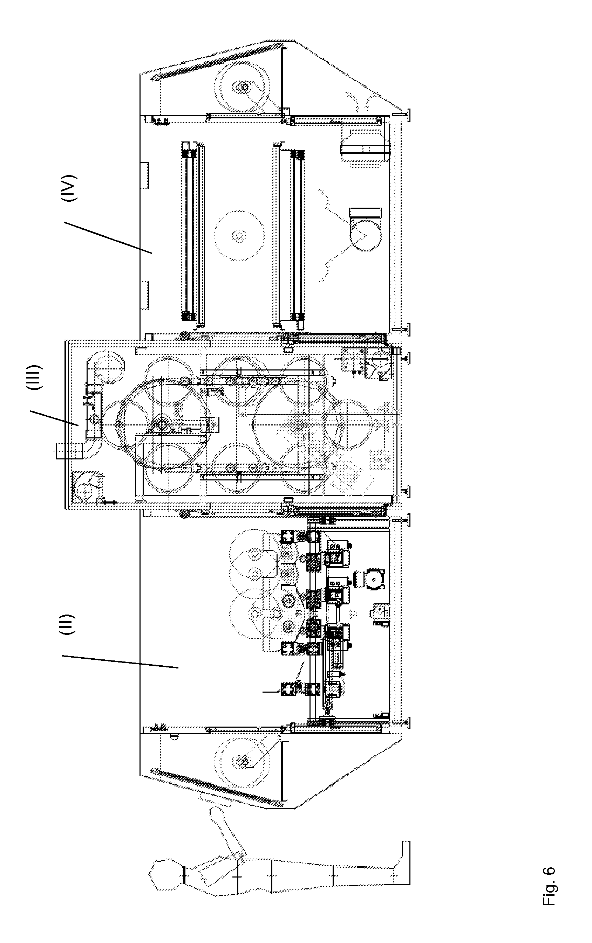

Die erfindungsgemäße Vorrichtung weist mindestens eine Auswascheinheit (II), eine Trocknungseinheit (III) sowie eine Nachbelichtungseinheit (IV) auf, welche in dieser Reihenfolge hintereinander angeordnet sind. In diesem Falle wird die bildmäßige Belichtung der fotopolymerisierbaren Sleeves in einer separaten Apparatur vorgenommen, und die Verarbeitung der Sleeves in der erfindungsmäßen Vorrichtung beginnt mit bereits bildmäßig belichteten Sleeves. Figur 6 zeigt beispielhaft eine Vorrichtung mit den Einheiten (II), (III) und (IV).

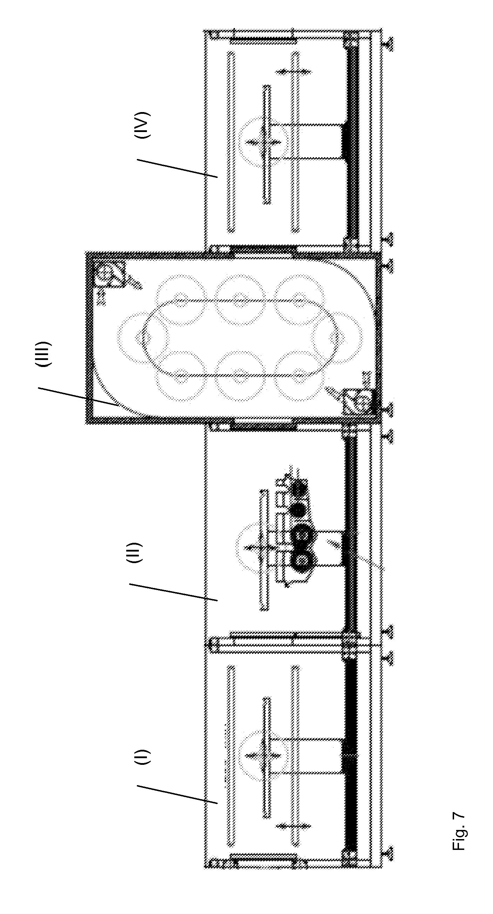

Die Vorrichtung kann optional auch noch eine Hauptbelichtungseinheit (I) vor der Auswascheinheit (II) aufweisen. In diesem Falle wird die bildmäßige Belichtung der fotopolymerisierbaren Sleeves ebenfalls in der erfindungsgemäßen Apparatur vorgenommen. Figur 7 zeigt beispielhaft eine Vorrichtung mit den Einheiten (I), (II), (III) und (IV).

Die Vorrichtung kann optional selbstverständlich noch weitere Einheiten umfassen, wie beispielsweise Speichermagazine zur Aufgabe fotopolymerisierbarer Sleeves oder Speichermagazine zur Aufnahme fertiger Sleeves.

Zwischen den einzelnen Einheiten befinden sich Türen, die zum Wechsel der Sleeves zwischen den einzelnen Einheiten geöffnet und wieder verschlossen werden. Das Öffnen und Schließen kann insbesondere vertikal erfolgen, beispielsweise mithilfe eines Kettenantriebs.

### Transportvorrichtung

Die Einheiten (II) und (IV) sowie -sofern vorhanden- auch die Einheit (I) umfassen erfindungsgemäß jeweils eine Transportvorrichtung (T).

Mit den Transportvorrichtungen können die Sleeves in die Einheit hinein und von dort aus zur jeweils nächsten Einheit bzw. aus der Vorrichtung heraus transportiert werden. Bei der ersten Einheit, also je nach Ausführungsform der Erfindung der Auswascheinheit (II) oder der Belichtungseinheit (I) werden die Sleeves durch die Transporteinheit (T) von außerhalb in die erfindungsgemäße Vorrichtung hinein transportiert und von dort aus an die nächste Einheit weitergegeben. Von der in Verarbeitungsrichtung gesehen letzten Einheit der Vorrichtung, der Nachbelichtungseinheit (IV), werden die Sleeves wieder aus der Vorrichtung heraus befördert.

Erfindungsgemäß umfasst die Transportvorrichtung (T) zwei parallel zueinander angeordnete Halterungen (H) zum Aufnehmen der beidseits der Sleeves überstehenden Achsen der auf Achsen montierten Sleeves, wobei die Halterungen (H) einen Abstand A zueinander aufweisen und für den Abstand die Beziehung L < A ≤ I gilt. Hierbei bezeichnet L wie oben definiert die Länge des Sleeves und I die Länge der Achse auf der der Sleeve montiert ist. Mit anderen Worten gesagt, befindet sich der Sleeve im Raum zwischen den beiden Halterungen (H).

In den Halterungen (H) werden die Achsen der Sleeves drehbar gelagert. Die Achsen werden hierbei bevorzugt in der Nähe ihrer Enden gehalten, besonders bevorzugt indem ein U-förmiges Lager der Halterung (H) in eine passende konzentrische Vertiefung der Transportachsen nahe der Achsenenden greift. "In der Nähe" ihrer Enden soll bedeuten, dass die Achsen in der Regel in einem Abschnitt von nicht mehr als 100 mm, bevorzugt nicht mehr als 50 mm von ihren Enden aus gesehen gehalten werden. Es sind aber auch größere Abstände von den Enden her denkbar, wobei aber ein zu weites Überstehen der Achsen über die Halterungen (H) hinaus vermieden werden sollte.

Figur 2 zeigt schematisch ein Ende eines auf einer Achse (2) befestigten Sleeves (1). In der Nähe des Endes der Achse ist eine konzentrische Vertiefung eingefräst, mittels derer die Achse in die Halterung (H) eingelegt werden kann. Die Achse kann, wie in der Figur dargestellt, eine zusätzliche Aussparung (11) am Ende aufweisen, welche zur Ankupplung einer Antriebseinheit zum Drehen der Achse verwendet werden kann.

Erfindungsgemäß sind die beiden Halterungen (H) in Längsrichtung der Vorrichtung, also der Verarbeitungsrichtung, doppelt translatorisch gelagert. Die Halterungen (H) sind also so gelagert, dass sie in Längsrichtung der Vorrichtung bewegt werden können, und somit den Transport der Sleeves innerhalb der Vorrichtung bewerkstelligen können. Der Begriff "doppelt translatorisch" bedeutet, dass zunächst einmal die Halterungen (H) mittels irgendeiner geeigneten Vorrichtung translatorisch, also in Längsrichtung verschiebbar gelagert sind, und dass weiterhin diese Vorrichtung selbst nochmals translatorisch gelagert ist. Durch diese doppelte translatorische Lagerung kann eine Transportvorrichtung (T) sehr kompakt gebaut werden.

In einer bevorzugten Ausführungsform der Erfindung weist die Transportvorrichtung (T) jeweils zwei parallel zueinander angeordnete Transportarme auf.

Die Transportarme sind jeweils so gelagert, dass sie in Längsrichtung verschiebbar sind. Sie werden hierzu in geeigneten Lagerungen verschiebbar gelagert, beispielsweise mithilfe geeigneter Rolllager. Die Lagerung kann auf voller Länge des Transportarms oder nur punktuell, in der Regel an mindestens zwei Stellen erfolgen. Das Verschieben in Längsrichtung kann beispielsweise mit Hilfe einer an den Transportarmen angebrachten Zahnschiene erfolgen, welche über einen Zahnradantrieb ein Verschieben des Transportarms in beide Richtungen entlang der Längsachse erlaubt.

Auf bzw. an jedem der beiden Transportarme ist jeweils eine der Halterungen (H) angebracht, und zwar so, dass die Halterungen (H) längs der Transportarme verschiebbar sind. Bei dieser bevorzugten Ausführungsform wird mit der Kombination aus einem verschiebbaren Transportarm sowie der ebenfalls verschiebbaren Halterung (H) die doppelt translatorische Lagerung der Halterung (H) erreicht. Auf diese Art und Weise ist ein sehr kompakter Bau der Vorrichtung möglich.

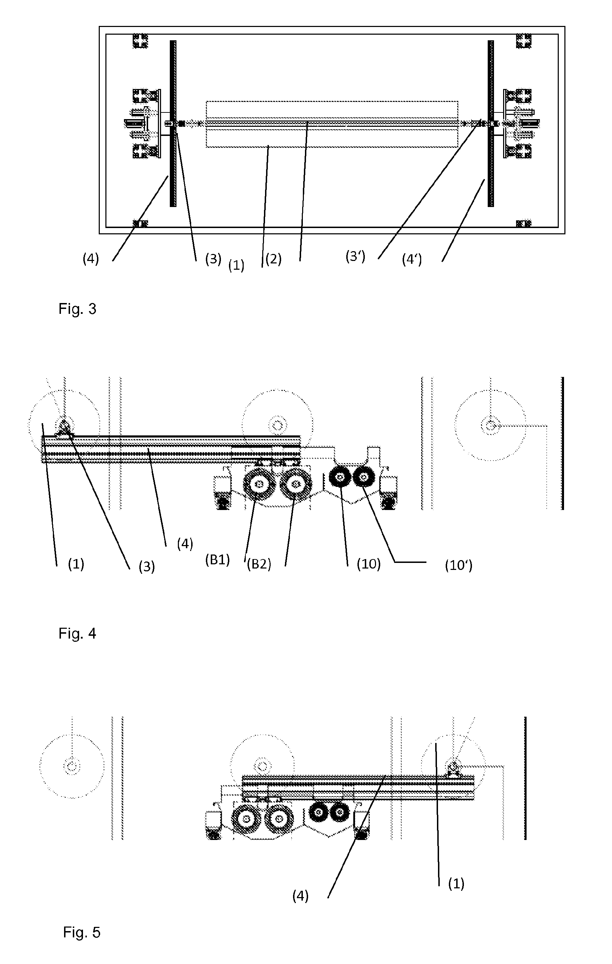

Figur 3 zeigt eine schematische Darstellung eines auf der Transportvorrichtung gelagerten Sleeves. Der Sleeve (1) ist auf einer Achse (2) gelagert, deren Enden jeweils in zwei Schlitten (3) bzw. (3') gelagert sind, welche ihrerseits auf zwei Transportarme (4) bzw. (4') gelagert sind.

In einer bevorzugten Ausführungsform der Erfindung ist die Transportvorrichtung (T) weiterhin in vertikaler Richtung beweglich gelagert, so dass sie aufwärts und abwärts bewegt werden kann.

Zum Übernehmen eines Sleeves können die Schlitten zunächst bis ans Ende der Transportarme gefahren werden. Anschließend reicht schon ein geringes Verschieben der Transportarme in die gleiche Richtung, so dass die Enden der Transportarme mit den Schlitten aus der Apparatur herausragen und ein Sleeve auf die Schlitten aufgelegt werden kann.

Figur 4 und Figur 5 zeigen exemplarisch die Funktionsweise der Transportvorrichtung (T) beim Transport eines Sleeves, und zwar beispielhaft bei einem Transport in die Auswascheinheit (II) hinein und weiter in die Trockeneinheit (III). Zur Übernahme eines Sleeves (1) fährt die Schiene (4) -in der Perspektive der Zeichnung- nach links aus und auch der Schlitten wird an das linke Ende der Schiene gefahren (Figur 4). Dort kann der auf Achsen montierte Sleeve in die Schlitten (3) eingelegt werden. Von dort kann der Sleeve durch das Verschieben der Schlitten und der Transportarme in die Auswaschvorrichtung bewegt werden. Der Weitertransport des Sleeves in die Trockeneinheit kann erfolgen, indem sich die Schiene und der Schlitten mit dem aufgelegten Sleeve -in der Perspektive der Zeichnung (Figur 5) nach rechts bewegen.

### Auswascheinheit (II)

Bei der Auswascheinheit kann es sich -abgesehen von der erfindungsgemäßen Transporteinheit (T)- um übliche Auswascheinheiten handeln, in denen die unbelichteten und dementsprechend nicht vernetzten Anteile der fotopolymerisierbaren Schicht mithilfe von geeigneten Auswaschmitteln entfernt werden.

Die Zusammensetzung des verwendeten Auswaschmittels richtet sich nach der Art der fotopolymerisierbaren Schicht. Es kann sich beispielsweise um Wasser, wässrige Lösemittelgemische oder um organische Lösemittelgemische handeln, beispielsweise um Auswaschmittel, welche hochsiedende Kohlenwasserstofffraktionen umfassen.

Zum Entfernen der unbelichteten Anteile werden üblicherweise zusätzliche mechanische Hilfsmittel verwendet, insbesondere eine oder mehrere Bürsten, welche mit dem Sleeve in Kontakt sind. Bei den Bürsten kann es sich um rotierende Bürsten handeln, und in der Regel rotiert der Sleeve während des Auswaschvorganges. Während des Auswaschvorganges kann der Sleeve in Drehung versetzt werden, indem die Achse, auf die der Sleeve montiert ist, von einer geeigneten Antriebseinheit in Drehung versetzt wird. Die Antriebseinheit wird vor dem Auswaschen auf geeignete Art und Weise mit der Achse verbunden. Die Antriebseinheit kann beispielsweise in Richtung der Achse seitlich der Position des Sleeves angeordnet sein. Nach dem Erreichen der Auswaschposition wird die Achse über eine geeignete Kupplung von der Antriebseinheit in Drehung versetzt.

Das Auswaschmittel kann beispielsweise auf die Bürste(n) aufgegeben werden, oder die Bürsten können in das Auswaschmittel zumindest teilweise eintauchen. Geeignete Auswascheinheiten sind dem Fachmann prinzipiell bekannt, beispielsweise aus der US 5,919,378.

### Bevorzugte Auswascheinheit (IIa)

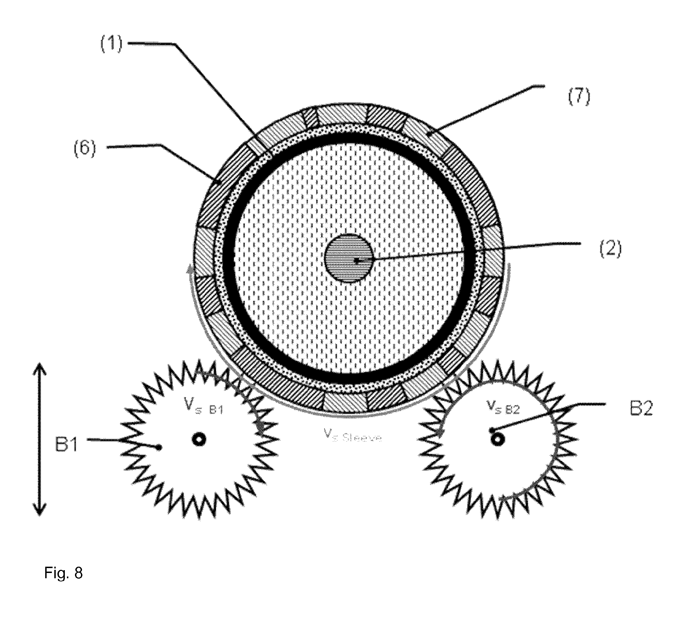

In einer bevorzugten Ausführungsform der Erfindung kann eine Auswascheinheit (IIa) eingesetzt werden, welche zwei rotierende Auswaschbürsten umfasst. Figur 8 zeigt schematisch die bevorzugte Ausführungsform der Auswascheinheit. Die Bürsten (B1) und (B2) sind in der Auswascheinheit (IIa) unterhalb des Sleeves (1) angeordnet, und sind mittels einer geeigneten Vorrichtung vertikal verschiebbar angeordnet. Die Bürsten berühren den Sleeve in Ruhestellung nicht. Zum Auswaschen wird der Sleeve, welcher seinerseits mittels der Achse (2) auf der Transporteinheit (T) (in Figur 8 nicht dargestellt) in der oben geschilderten Art und Weise aufliegt, in eine Position oberhalb der Auswaschbürsten gefahren. Nach dem Erreichen der Auswaschposition wird die Antriebseinheit (in Figur 8 nicht dargestellt) für den Sleeve mit der Achse verbunden. Weiterhin werden nun die Bürsten zum Auswaschen von unten her an den Sleeve (1) gefahren, bis sie in ausreichendem Kontakt mit dem Sleeve sind. Nach Beendigung des Auswaschvorganges können die Bürsten (B1) und (B2) wieder nach unten vom Sleeve weggefahren werden. Diese Bewegung der Bürsten ist in Figur 8 mittels des Doppelpfeils angedeutet. Der Sleeve (1) ist bereits bildmäßig belichtet und weist vernetzte, unlösliche Bereiche (6) sowie unvernetzte, im Auswaschmittel lösliche Bereiche (7) auf. Der Abstand der beiden Bürsten zueinander ist üblicherweise konstant zueinander. Die Auswascheinheit erlaubt es, auch Sleeves unterschiedlichen Durchmessers zu verarbeiten.

Bei der bevorzugten Auswascheinheit (IIa) verfügen der Sleeve und die Bürsten (B1) und (B2) jeweils über separate Antriebsvorrichtungen, mit denen sich die Drehrichtung sowie die Drehgeschwindigkeit des Sleeves und der beiden Bürsten jeweils separat voreinander regeln lässt.

Zum Auswaschen wird der Sleeve in Rotation versetzt. Die beiden Bürsten (B1) und (B2) drehen sich gegensinnig zueinander, so dass die eine der beiden Bürsten die gleiche Rotationsrichtung aufweist wie der Sleeve und die zweite Bürste die umgekehrte Rotationsrichtung aufweist. In der Darstellung der Figur 8 dreht sich der Sleeve im Uhrzeigersinn, die Bürste (B1) ebenfalls im Uhrzeigersinne und die Bürste (B2) entgegen dem Uhrzeigersinn. Die Drehrichtung ist in Figur 8 jeweils durch Pfeile angedeutet.

In Bezug auf die Oberflächenbewegung (d.h. die Bahnbewegung an der Oberfläche des Sleeves bzw. der Bürsten B1 und B2) am Ort des Kontakts der Auswaschbürsten (B1) bzw. (B2) bedeutet dies, dass die Oberflächenbewegungen des Sleeves und der gleichsinnig rotierenden Bürste (B1) einander entgegengesetzt sind, während die Oberflächenbewegungen des Sleeves und der gegensinnig rotierenden Bürste (B2) die gleiche Richtung haben.

Erfindungsgemäß dreht sich die gegensinnig zum Sleeve rotierende Bürste (B2) schneller als die gleichsinnig zum Sleeve rotierende Bürste (B1), und zwar ist die Oberflächengeschwindigkeit der Bürste (B1) V_{B1} kleiner als die Oberflächengeschwindigkeit des Sleeves vₛ, und die Oberflächengeschwindigkeit der Bürste (B2) v_{B2} ist größer als die Oberflächengeschwindigkeit des Sleeves vₛ, d.h. es gilt |v_{B2}| > |v_{S}| > |v_{B1}| > 0.

Besonders bevorzugt wird die Geschwindigkeit der Bürsten so eingestellt, dass die Differenz der Oberflächengeschwindigkeiten zwischen dem Sleeve und B1 bzw. B2 jeweils ungefähr gleich groß ist, d.h. es gilt |v_{S}| - |v_{B1}| ≈ |v_{B2}| - |v_{S}|. Der Begriff "ungefähr gleich" soll dabei bedeuten, dass die Differenzen im Rahmen üblicher technischer Variationsbreiten gleich sind. Zumindest aber sollten Abweichungen (Δv1^{OF} - Δv2^{OF}) / (Δv1^{OF} + Δv2^{OF}) < 0,2 sein, bevorzugt < 0,1 und besonders bevorzugt < 0,05, wobei Δv1^{OF} = |vₛ| - |v_{B1}| und Δv2^{OF} = |v_{B2}| - |v_{S}|.
Diese Geschwindigkeitseinstellung bewirkt, dass die Oberfläche des Sleeves während des Auswaschens einmal in Drehrichtung und einmal entgegen der Drehrichtung des Sleeves gebürstet wird, wobei aufgrund der konstanten Geschwindigkeitsdifferenz die mechanische Belastung der Oberfläche des Sleeves jeweils gleich ist. Hierdurch wird eine besonders gute und gleichzeitig schonende Entfernung der unvernetzten Anteile der Schicht erreicht.

Die Geschwindigkeitsdifferenz kann vom Fachmann je nach der Natur der fotopolymerisierbaren Schicht eingestellt werden. Sie wird bevorzugt auch bei Sleeves unterschiedlichen Durchmessers jeweils auf den gleichen Wert eingestellt. Dadurch bleibt die mechanische Belastung der Reliefschicht unabhängig vom Durchmesser des Sleeve konstant, und dementsprechend ist auch die Auswaschgeschwindigkeit des Sleeves unabhängig vom Durchmesser des Sleeves konstant. Dies ist ein besonderer Vorteil der bevorzugten Ausführungsform der Auswascheinheit gegenüber einer üblichen Auswascheinheit mit konstanter Rotationsgeschwindigkeit der Bürsten, denn bei Letzterer ändert sich bei einer Änderung des Sleevedurchmessers naturgemäß die Differenz der Oberflächengeschwindigkeit und dementsprechend die mechanische Belastung.

Bewährt hat sich eine Geschwindigkeitsdifferenz von 1 bis 50 m/min, bevorzugt 5 bis 40 m/min und besonders bevorzugt 10 bis 20 m/min.

Das Auswaschmittel kann direkt auf die Bürsten aufgegeben werden. In einer bevorzugten Ausführungsform der Erfindung kann sich das Auswaschmittel in einem offenen Vorratsgefäß, beispielsweise einer Wanne befinden, welche unterhalb der Bürsten angeordnet ist, und wobei die Bürsten jeweils mit ihrer Unterseite in das Auswaschmittel eintauchen. Sie sollten aber nicht zu weit eintauchen. Bewährt hat es sich, die Bürsten an der Unterseite von der äußeren Bürstenoberfläche an, 10 mm bis 50 mm, bevorzugt 10 mm bis 30 mm tief in das Lösemittel einzutauchen.

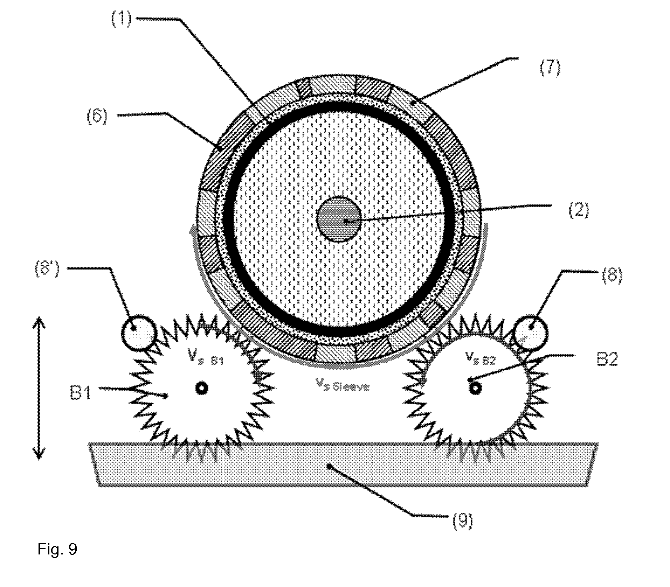

Überschüssiges Lösemittel auf den Bürsten kann vorteilhaft mittels geeigneter Rakel entfernt werden. Die Rakel sollten im Regelfalle, jeweils in Drehrichtung gesehen, zwischen der Befeuchtung der Bürsten mit dem Auswaschmittel und dem Kontakt der Bürste mit dem Sleeve angeordnet werden. Sie können beispielsweise vorteilhaft in Position 9 bis 11 Uhr bzw. 1 bis 3 Uhr angeordnet werden. Eine derartige Ausführungsform ist exemplarisch in Figur 9 gezeigt, sie zeigt die Bürsten (B1) und (B2), welche in eine Wanne (9) mit dem Auswaschmittel tauchen, und zwei Rakel (8) bzw. (8') zum Entfernen überschüssigen Lösemittels. Die Rakel sorgen vorteilhaft dafür, dass mit den ausgewaschenen Bestandteilen der fotopolymerisierbaren Schicht verunreinigtes Auswaschmittel effizient von der Bürste entfernt werden kann. Es ist bei der bevorzugten Auswascheinheit (IIa) nicht erforderlich, die Auswaschbürsten zum Reinigen von Zeit zu Zeit vollständig in Auswaschmittel zu tauchen. Dementsprechend muss in der Wanne auch nur wenig Lösemittel vorrätig gehalten werden.

In einer weiteren bevorzugten Ausführungsform ist die Auswascheinheit mit einem Lösemittelkreislauf ausgestattet, welcher eine Messeinheit zur Überwachung des Feststoffgehaltes im Lösemittel aufweist (d.h. des Anteils im Lösemittel gelöster Bestandteile der fotopolymerisierbaren Schicht). Beim erfindungsgemäßen Lösemittelkreislauf wird der Wanne kontinuierlich Lösemittel entnommen, welches nach dem Durchlaufen des Kreislaufs wieder kontinuierlich in die Wanne zurückgeführt wird. Der Kreislauf umfasst eine Vorrichtung zum Umpumpen des Auswaschmittels, einen Ablauf für verbrauchtes Auswaschmittel und einen Zulauf für frisches Auswaschmittel. Vorteilhaft umfasst der Kreislauf weiterhin eine Vorrichtung zum Temperieren des Auswaschmittels. Hierdurch wird eine besonders elegante und schnelle Temperierung des Lösemittels erreicht. Erfindungsgemäß umfasst der Kreislauf weiterhin eine kontinuierlich arbeitende Messeinheit zur Bestimmung des Feststoffgehaltes. Derartige Messeinheiten sind dem Fachmann prinzipiell bekannt. Hierdurch wird kontinuierlich der Feststoffgehalt überwacht. Frisches Lösemittel wird nur dann nachdosiert, wenn der Feststoffgehalt im Auswaschmittel eine bestimmte Grenze überschreitet. Im Regelfall ist eine Beladung des Auswaschmittels mit bis zu 5 Gew.-% Feststoffen ohne Qualitätsbeeinträchtigung möglich. Ein Nachdosieren ist erst beim Überschreiten dieser Grenze erforderlich. Hierdurch wird das Auswaschmittel besonders effizient genutzt, und dementsprechend ist die zum Auswaschen eines Sleeves benötigte Lösemittelmenge relativ klein. Da sich darüber hinaus nur ein Teil des Auswaschmittels in der offenen Wanne befindet und der Rest des Auswaschmittels im geschlossenen Kreislauf, ist dementsprechend auch die Menge freigesetzter Lösemitteldämpfe relativ gering.

Vor dem Weitertransport in die Trockeneinheit (III) ist es empfehlenswert, den Sleeve vorzutrocknen. Dies dient dazu, Lösemitteltropfen auf der Oberfläche des Sleeves zu vermeiden, welche nach dem Trocknen zu Störungen im Druckbild führen könnten. Die Vortrocknung kann vorgenommen werden, indem man den Sleeve nach dem Auswaschen für eine bestimmte Zeitspanne ohne Kontakt mit den Auswaschbürsten rotieren lässt, oder mit einer oder mehreren zusätzlichen Trockenbürsten kontaktiert.

In einer weiteren bevorzugten Ausführungsform umfasst die Auswascheinheit zwei zusätzliche Bürsten (10) und (10'), mit denen eine kombinierte Nachreinigung und Vortrocknung durchgeführt wird. Dies ist schematisch in Figur 4 gezeigt. Die zusätzlichen Bürsten sind in Verarbeitungsrichtung nach den Auswaschbürsten angeordnet und können wie die Auswaschbürsten von unten an den Sleeve gefahren werden. Beide Bürsten weisen bevorzugt Rakel auf, die in ähnlichen Positionen wie die Auswaschbürsten angeordnet sind.

Zur Nachreinigung und Vortrocknung wird der Sleeve mittels der Transportvorrichtung zunächst zu den Bürsten (10) bzw. (10') transportiert. Mittels der ersten der beiden Bürsten wird zunächst einmal unter Verwendung von wenig frischem Auswaschmittel der bereits ausgewaschene Sleeve nachgereinigt. Die zweite Bürste dient als reine Trockenbürste, mit der Lösemittelreste von der Oberfläche des Sleeves aufgenommen werden. Anschließend ist es empfehlenswert, den Sleeve nochmals ohne Bürstenkontakt einige Minuten rotieren zu lassen, beispielsweise 1 bis 3 min. Diese Maßnahmen dienen dazu, dass keine Lösemitteltropfen mehr auf der Oberfläche des Sleeves vorhanden sind, bevor der Sleeve in die Trockeneinheit gefahren wird.

Die Auswascheinheit kann weiterhin eine Absaugung für Dämpfe des Auswaschmittels aufweisen.

### Trockeneinheit (III)

Von der Auswascheinheit (II) wird der Sleeve mittels der Transportvorrichtung (T) der Auswascheinheit in die Trockeneinheit (III) befördert.

Bei der Trockeneinheit (III) kann es sich um eine übliche Trockeneinheit handeln, bei der die zu trocknenden Sleeves auf einem Karussell im Kreis herumgefahren werden. Dies ist schematisch in den Figuren 6 und 7 gezeigt. Beispielsweise kann es sich um eine Trockeneinheit wie von US 5,919,378, insbesondere in Spalte 3, Zeilen 16 bis 30 offenbart handeln. Die Sleeves werden in das Karussell in entsprechende Halterungen im Karussell-Umlauf mittels ihrer Achsen eingelegt. Die Trockeneinheit umfasst in prinzipiell bekannter Art und Weise ein Warmluftgebläse und eine Absaugung für die Lösemitteldämpfe. Die Trocknung erfolgt üblicherweise bei 40°C bis 90°C, bevorzugt 50°C bis 70°C.

Um Wärmeverluste zu vermeiden kann in einer vorteilhaften Ausführungsform der Erfindung die zum Trocknen verwendete Luft ganz oder teilweise im Kreis gefahren werden. Der Luftkreislauf kann in prinzipiell bekannter Art und Weise auch Wärmetauscher und/oder Vorrichtungen zum Abtrennen von Lösemitteldämpfen aus dem Trockenluftstrom umfassen.

### Nachbelichtungseinheit (IV)

In der Nachbelichtungseinheit werden die Sleeves mit UV-Strahlung, insbesondere UV-C-Strahlung nachbelichtet.

Die Nachbelichtungseinheit weist eine Transportvorrichtung (T) auf, mit der die Sleeves von der Trockeneinheit in die Nachbelichtungseinheit (IV) transportiert werden können sowie - nach der Nachbelichtung- von der Nachbelichtungseinheit (IV) aus der erfindungsgemäßen Vorrichtung hinaus. Die Funktionsweise der Transportvorrichtung wurde bereits eingangs geschildert.

Die zum Nachbelichten notwendigen UV-Röhren sind bevorzugt oberhalb und unterhalb des Sleeves angeordnet und der Sleeve rotiert während der Nachbelichtung.

### Hauptbelichtungseinheit (I)

Die erfindungsgemäße Vorrichtung kann optional auch noch eine Hauptbelichtungseinheit (I) vor der Auswascheinheit (II) aufweisen. In diesem Falle wird die bildmäßige Belichtung der fotopolymerisierbaren Sleeves mit aktinischem Licht ebenfalls in der erfindungsgemäßen Apparatur vorgenommen.

Die Hauptbelichtungseinheit ist erfindungsgemäß ebenfalls mit der erfindungsgemäßen Transportvorrichtung (T) ausgestattet, mit der die Sleeves in die Hauptbelichtungseinheit (I) hinein und von dort weiter in die Auswaschvorrichtung (II) transportiert werden können.

Bei den zur Belichtung notwendigen Strahlungsquellen kann es sich um beliebige Strahlungsquellen handeln, welche aktinisches Licht aussenden, also Licht, welches in der fotopolymerisierbaren Schicht Vernetzung auslöst. In der Regel handelt es sich hierbei um UV-A- bzw. UV-VIS-Strahlung. Diese kann prinzipiell von allen Strahlungsquellen erzeugt werden, welche UV-Licht aussenden, beispielsweise von UV-Röhren. Die Lichtquellen sind bevorzugt oberhalb und unterhalb des Sleeves angeordnet, welcher während des Belichtens rotiert.

In einer bevorzugten Ausführungsform der Erfindung handelt es sich um eine Hauptbelichtungseinheit, mittels der zwei Sleeves auf einmal mit aktinischem Licht bestrahlt werden können.

### Transport der Sleeves mittels der Transporteinheit

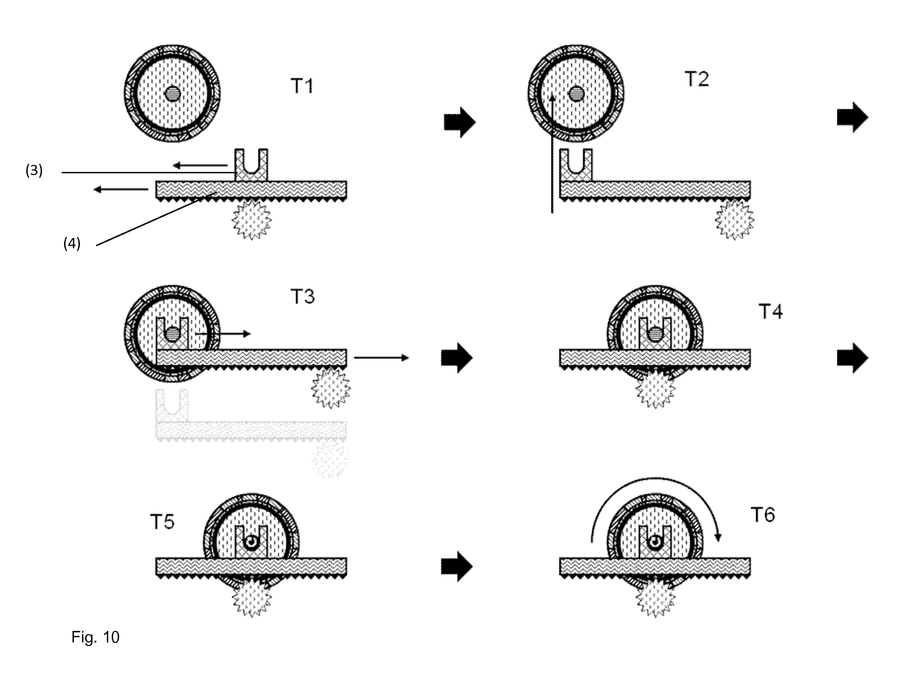

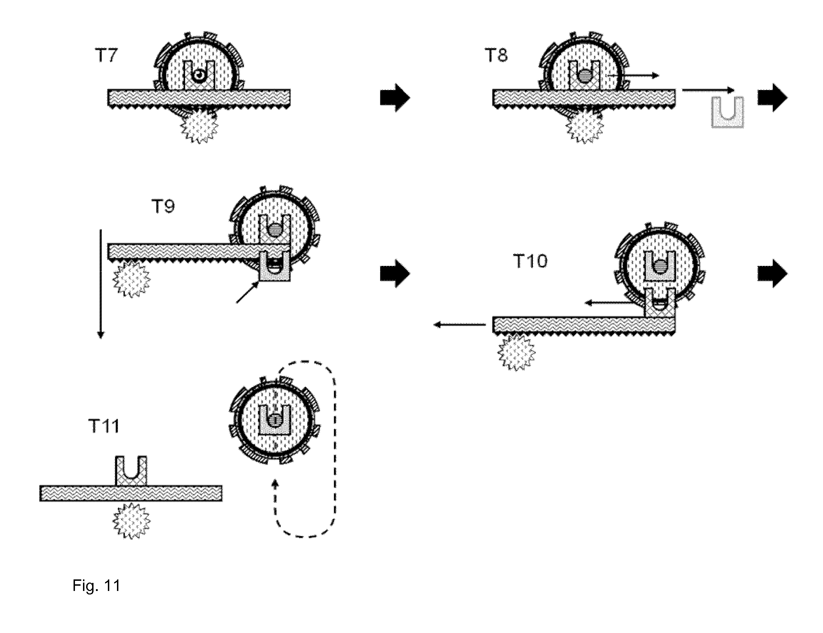

Der Transport der Sleeves mittels der bevorzugten Transporteinheit (IIa) in die Auswascheinheit (II) hinein und von dort aus weiter in die Transporteinheit (III) wird zur Illustration nachfolgend nochmals beispielhaft anhand der Figuren 10 und 11 mit den Einzeldarstellungen T1 bis T11 schematisch dargestellt, ohne dass damit andere Vorgehensweise ausgeschlossen werden sollen.

Zum Aufnehmen eines neuen Sleeves fahren die Halterung H (3) und der Transportarm 4 nach links aus der Vorrichtung heraus (Darstellung T1). Der Sleeve befindet sich in einer auf seinen Achsen in einer Halterung außerhalb der Apparatur. Zum Übernehmen des Sleeves wird der Transportarm vertikal nach oben bewegt (T2). Nun werden Halterung und Transportarm wieder nach rechts in die Auswaschapparatur hineingefahren (T3) bis an die zum Auswaschen mit den Bürsten (nicht dargestellt) erforderliche Stelle (T4). Dann wird zunächst der Antrieb zur Rotation des Sleeves mit der Sleeveachse gekoppelt (T5) und der Auswaschvorgang unter Drehung des Sleeves vorgenommen (T6). Nach Beendigung des Auswaschvorganges (ein eventuellen Nachtrocknen wird nicht gezeigt) wird die Achse des Sleeve wieder vom Antrieb getrennt (T7) und die Halterung und der Transportarm fahren weiter nach rechts zur Trockeneinheit (III) (T8). Das Karussell der Trockeneinheit weist ebenfalls eine U-förmige Halterung für den Sleeve auf, allerdings in unterschiedlichem Abstand als die Halterungen der Transporteinheit. Durch Herunterfahren der Transportarme wird der Sleeve nun in den Halterungen des Karussells des Trockners abgelegt (T9) und die Halterung H und der Transportarm wieder zurückgefahren (T10). Der Sleeve kann nun in der Trockeneinheit (III) getrocknet werden (T11).

### Verfahren

Mittels der erfindungsgemäßen Vorrichtung können druckfertige Sleeves vollautomatisch in einer Fertigungslinie hergestellt werden.
Das erfindungsgemäße Verfahren umfasst zumindest die Verfahrensschritte
(1) bildmäßiges Belichten der fotopolymeriserbaren Schicht mittels aktinischer Strahlung,
(2) Entfernen unbelichteter Anteile der bildmäßig belichteten Sleeves mithilfe von Auswaschmitteln,
(3) Trocknen der ausgewaschenen Sleeves, sowie
(4) Nachbelichten der Sleeves mit UV-Strahlung,
wobei man die Verfahrensschritte (2), (3) und (4) in der erfindungsgemäßen Apparatur umfassend mindestens die Einheiten (II), (III) und (IV) durchführt. Schritt (1) kann separat oder für den Fall, dass die erfindungsgemäße Vorrichtung ebenfalls eine Hauptbelichtungseinheit (I) umfasst, auch in der erfindungsgemäßen Apparatur durchgeführt werden. Einzelheiten zur Durchführung der Verfahrensschritte wurden bereits oben geschildert. Auch bei einer separaten Durchführung des Belichtungsschrittes (1) werden die Sleeves bevorzugt wie oben geschildert auf Achsen montiert, so dass sie zur Verarbeitung in der erfindungsgemäßen Apparatur nicht neu montiert werden müssen.

### Vorteile

Die erfindungsgemäße Vorrichtung weist eine Reihe von Vorteilen auf.

Durch die Transportvorrichtung (T) sowie den Verzicht auf eine Absaugestation vor der Auswascheinheit ist ein sehr kompakter Bau der Vorrichtung möglich. Es lassen sich (ohne die Hauptbelichtungseinheit) Vorrichtungen mit einer Länge von nur ca. 5 m bauen, während marktübliche Vorrichtungen länger sind. Die Vorrichtung kann also auch in kleineren Räumen aufgestellt werden. Durch die kompakte Bauweise der erfindungsgemäßen Vorrichtung ist weiterhin eine Verkürzung von Prozesszeiten bei gleichzeitig verminderter Anfälligkeit für Transportstörungen gegeben, wodurch die Produktivität der Verarbeitung von Sleeves erhöht wird.

Die bevorzugte Auswascheinheit mit Auswaschmittelkreislauf und Feststoffkontrolle erlaubt eine deutliche Reduzierung der Menge an Auswaschmittel.

Durch das Konstanthalten der Geschwindigkeitsdifferenz zwischen Sleeve und Auswaschbürsten durch automatisches Anpassen der Oberflächengeschwindigkeit von Sleeves und Auswaschbürsten bei verändertem Sleevedurchmesser ist die erforderliche Auswaschzeit für alle Sleevedurchmesser gleich. Es ist nicht mehr erforderlich, die Auswaschzeit für jeden Sleevedurchmesser neu zu bestimmen.

## Patentansprüche

1. Vorrichtung zum Herstellen von Flexodrucksleeves umfassend mindestens
(II) eine Auswascheinheit zum Entfernen unbelichteter Anteile bildmäßig belichteter Sleeves mithilfe von Auswaschmitteln,
(III) eine Trockeneinheit zum Entfernen von Resten der Auswaschmittel aus den ausgewaschenen Sleeves, sowie
(IV) eine Nachbelichtungseinheit zum Nachbelichten der Sleeves mit UV-Strahlung, wobei die Einheiten (II), (III) und (IV) in der genannten Reihenfolge unmittelbar hintereinander angeordnet sind, die Sleeves eine Länge L aufweisen und zur Verarbeitung in der Vorrichtung mithilfe geeigneter Haltevorrichtungen konzentrisch auf Achsen der Länge I gelagert sind, so dass die Sleeves während der Verarbeitung rotieren können, mit der Maßgabe, dass I > L ist, und wobei weiterhin die Einheiten (II) und (IV) jeweils eine Transportvorrichtung (T) aufweisen, mit denen die Sleeves in die Einheit hinein und von dort aus zur jeweils nächsten Einheit bzw. aus der Vorrichtung heraus transportiert werden können,
**dadurch gekennzeichnet, dass**
• die Transportvorrichtung (T) zwei parallel zueinander angeordnete Halterungen (H) in einem Abstand A zum Aufnehmen der beidseits der Sleeves überstehenden Achsen der auf Achsen montierten Sleeves aufweist, wobei für A die folgende Beziehung L < A ≤ I gilt, und
• wobei die Halterungen (H) doppelt translatorisch in Längsrichtung der Vorrichtung gelagert sind.

2. Vorrichtung gemäß Anspruch 1, **dadurch gekennzeichnet, dass**
• die Transportvorrichtung (T) jeweils zwei parallel zueinander angeordnete Transportarme umfasst,
• die Transportarme so gelagert sind, dass sie in Längsrichtung verschiebbar sind, und
• auf jedem der Transportarme eine längs der Transportarme verschiebbare Halterung (H) angeordnet ist.

3. Vorrichtung gemäß Anspruch 2, **dadurch gekennzeichnet, dass** die Transportvorrichtung (T) weiterhin in vertikaler Richtung beweglich gelagert ist.

4. Vorrichtung gemäß einem der Ansprüche 1 bis 3, **dadurch gekennzeichnet, dass** die Transportarme die Achsen jeweils in der Nähe von ihren Enden aufnehmen können.

5. Vorrichtung gemäß einem der Ansprüche 1 bis 4, **dadurch gekennzeichnet, dass** die Vorrichtung zusätzlich eine vor der Auswascheinheit (II) angeordnete Belichtungseinheit (I) umfasst, in welcher fotopolymerisierbare Sleeves bildmäßig mit aktinischer Strahlung belichtet werden können, und wobei die Belichtungseinheit (I) ebenfalls eine Transportvorrichtung (T) aufweist.

6. Vorrichtung gemäß einem der Ansprüche 1 bis 5, **dadurch gekennzeichnet, dass** es sich bei der Auswascheinheit (II) um eine Auswascheinheit (IIa) handelt, welche zwei gegensinnig rotierende Auswaschbürsten (B1) und (B2) umfasst, die unterhalb des Sleeves angeordnet sind, mit der Maßgabe, dass sich Drehgeschwindigkeit des Sleeves und der beiden Bürsten (B1) und (B2) jeweils separat voreinander regeln lassen.

7. Vorrichtung gemäß Anspruch 6, **dadurch gekennzeichnet, dass** die Auswaschbürsten (B1) und (B2) mittels einer geeigneten Vorrichtung in vertikaler Richtung verschiebbar sind, so dass sie aus einer Ruheposition, in der die Bürsten keinen Kontakt mit dem Sleeve haben, in die Arbeitsstellung, in der die Bürsten Kontakt mit dem Sleeve haben, bewegt werden können.

8. Vorrichtung gemäß einem der Ansprüche 6 oder 7, **dadurch gekennzeichnet, dass** die Auswaschbürsten (B1) und (B2) jeweils mit mindestens einem Rakel zur Entfernung überschüssigen Auswaschmittels und/oder zur Entfernung von Verunreinigungen von der Bürste ausgestattet sind.

9. Vorrichtung gemäß einem der Ansprüche 6 bis 8, **dadurch gekennzeichnet, dass** unterhalb der Auswaschbürsten (B1) und (B2) eine nach oben offene Wanne zur Aufnahme des Auswaschmittels angeordnet ist, wobei die Bürsten mit ihrer Unterseite in das Auswaschmittel eintauchen.

10. Vorrichtung gemäß Anspruch 9, **dadurch gekennzeichnet, dass** die Auswascheinheit mit einem Auswaschmittelkreislauf ausgestattet ist, mittels welchem der Wanne kontinuierlich Auswaschmittel entnommen und wieder in die Wanne zurückgeführt wird, und wobei der Kreislauf eine Messeinheit zur Überwachung des Feststoffgehaltes im Auswaschmittel umfasst.

11. Verfahren zum Herstellen von Flexodrucksleeves ausgehend von fotopolymerisierbaren Sleeves umfassend mindestens eine zylindrische Hülse sowie eine darauf aufgebrachte fotopolymerisierbare Schicht, mindestens umfassend die folgenden Verarbeitungsschritte:
(1) bildmäßiges Belichten der fotopolymerisierbaren Schicht mittels aktinischer Strahlung,
(2) Entfernen unbelichteter Anteile der bildmäßig belichteten Sleeves mithilfe von Auswaschmitteln,
(3) Trocknen der ausgewaschenen Sleeves, sowie
(4) Nachbelichten der Sleeves mit UV-Strahlung,
**dadurch gekennzeichnet, dass** man mindestens die Verfahrensschritte (2), (3) und (4) in einer Vorrichtung gemäß einem der Ansprüche 1 bis 10 durchführt.

12. Verfahren gemäß Anspruch 11, **dadurch gekennzeichnet, dass** es sich um eine Vorrichtung gemäß einem der Ansprüche 4 bis 10 handelt und man auch Verfahrensschritt (1) in der Vorrichtung durchführt.

13. Verfahren gemäß Anspruch 11 oder 12, **dadurch gekennzeichnet, dass** es sich um eine Vorrichtung umfassend eine Auswascheinheit (IIa) mit zwei gegensinnig zueinander rotierenden Auswaschbürsten (B1) und (B2) gemäß einem der Ansprüche 6 bis 10 handelt, wobei (B1) gleichsinning zum Sleeve und (B2) gegensinning zum Sleeve rotiert, und wobei für die Oberflächengeschwindigkeiten des Sleeves vₛ, der Bürste (B1) v_{B1} sowie der Bürste (B2) v_{B2} die folgende Beziehung gilt |v_{B2}| > |v_{S}| > |v_{B1}| > 0.

14. Verfahren gemäß Anspruch 13, **dadurch gekennzeichnet, dass** die Drehgeschwindigkeit der Büsten so eingestellt wird, dass die Differenz der Beträge der Oberflächengeschwindigkeiten zwischen Sleeve und (B1) bzw. (B2) jeweils ungefähr gleich groß sind.

## Claims

1. Device for producing flexographic printing sleeves comprising at least
(11) a clean-out unit for removing unexposed portions of image-exposed sleeves using cleaning agent,
(III) a drying unit for removing residual cleaning agent from the cleaned out sleeves, and
(IV) a post-exposure unit for re-exposing the sleeves with UV radiation, wherein units (II), (III) and (IV) are arranged directly one after the other in the sequence given, the sleeves have length L and for the purposes of processing in the device are mounted concentrically on axles of length 1 by way of suitable support devices so that the sleeves can rotate during the processing, with the condition that 1 > L, and wherein furthermore each of units (II) and (IV) comprises a transport device (T) for transporting the sleeves into the unit and from there to the next respective unit or out of the device,
**characterized in that**
• the transport device (T) comprises two supports (H) for holding the axles of the sleeves mounted thereon, said axles extending out from both sides of the sleeves and said supports being disposed parallel to one another at a distance A, wherein for A, the following relationship holds; L < A ≤ 1, and
• wherein the supports (H) are mounted dually translationally in the longitudinal direction of the device.

2. Device according to Claim 1, **characterized in that**
• each of the the transport devices (T) comprises two transport arms disposed parallel to one another,
• the transport arms are mounted in such a way that they can move in the longitudinal direction, and
• a support (H) is disposed on each of the transport arms, the supports able to move along the transport arms.

3. Device according to Claim 2, **characterized in that** the transport device (T) is also movably mounted in the vertical direction.

4. Device according to one of Claims 1 to 3, **characterized in that** the transport arms can hold the axles near the ends thereof.

5. Device according to one of Claims 1 to 4, **characterized in that** the device also comprises an exposure unit (I) disposed before the clean-out unit (II) in which photopolymerizable sleeves can be image-exposed with actinic radiation, and wherein the exposure unit (I) also comprises a transport device (T).

6. Device according to one of Claims 1 to 5, **characterized in that** the clean-out unit (II) is a clean-out unit (IIa) comprising two clean-out brushes (B1) and (B2) that rotate in the same direction and that are disposed below the sleeve, with the requirement that the rotational velocity of the sleeve and of the two brushes (B1) and (B2) can be regulated separately of one another.

7. Device according to Claim 6, **characterized in that** the clean-out brushes (B1) and (B2) can be moved in the vertical direction by way of a suitable device, such that they can be moved from a rest position in which the brushes make no contact with the sleeve to the working position in which the brushes contact the sleeve.

8. Device according to one of Claims 6 or 7, **characterized in that** each of the clean-out brushes (B1) and (B2) is equipped with at least one doctor blade for removing excess cleaning agent and/or for removing contamination from the brush.

9. Device according to one of Claims 6 to 8, **characterized in that** a pan that is open upward is disposed below the clean-out brushes (B1) and (B2), the pan holding the cleaning agent, wherein the bottom side of the brushes dips into the cleaning agent.

10. Device according to Claim 9, **characterized in that** the clean-out unit is equipped with a cleaning agent circuit for continuously withdrawing cleaning agent from the pan and returning it to the pan, and wherein the circuit comprises a measuring unit for monitoring the solids content in the cleaning agent.

11. Method for producing flexographic printing sleeves starting with photopolymerizable sleeves, comprising at least one cylindrical sleeve and a photopolymerizable layer applied thereto, the method comprising at least the processing steps of:
(1) imaging exposure of the photopolymerizable layer using actinic radiation,
(2) removal of unexposed portions of the image-exposed sleeves using cleaning agent,
(3) drying the cleaned out sleeves, and
(4) post-exposure of the sleeves with UV radiation,
**characterized in that** at least process steps (2), (3) and (4) are performed in a device according to one of Claims 1 to 10.

12. Method according to Claim 11, **characterized in that** the device is a device according to one of Claims 4 to 10 and that process step (1) is also performed in the device.

13. Method according to Claim 11 or 12, **characterized in that** the device is a device according to one of Claims 6 to 10 comprising a clean-out unit (IIa) with two clean-out brushes (B1) and (B2) that rotate in opposite directions from one another, wherein (B1) rotates in the same direction as the sleeve and (B2) rotates in the opposite direction to the sleeve, and wherein the following relationship applies to the surface velocities of the sleeve vₛ, brush (B1) v_{B1} and brush (B2) v_{B2} : |v_{B2}| > |v_{S}| > |v_{B1}| > 0.

14. Method according to Claim 13, **characterized in that** the rotational velocity of the brushes is adjusted such that the difference in the magnitudes of the surface velocities between the sleeve and (B1) or (B2) are approximately the same in each case.

## Revendications

1. Dispositif pour fabriquer des manchons pour impression flexographique, comprenant au moins
(II) une unité de rinçage pour éliminer les parties non exposées des manchons exposés sous forme d'images à l'aide d'agents de rinçage,
(III) une unité de séchage pour éliminer les résidus des agents de rinçage hors des manchons rincés, et
(IV)une unité de post-exposition pour post-exposer les manchons avec un rayonnement UV, les unités (II), (III) et (IV) étant disposées directement les unes derrière les autres dans l'ordre mentionné, les manchons présentant une longueur L et étant supportés pour le traitement dans le dispositif, à l'aide de dispositifs de fixation appropriés, concentriquement sur des axes de longueur 1, de sorte que les manchons puissent tourner pendant le traitement à condition que 1 > L, et en outre les unités (II) et (IV) présentant chacune un dispositif de transport (T), avec lesquels les manchons peuvent être transportés à l'intérieur de l'unité et de là vers l'extérieur jusqu'à l'unité suivante respective ou hors du dispositif,
**caractérisé en ce que**
- le dispositif de transport (T) présente deux fixations (H) disposées parallèlement l'une à l'autre à une distance A pour recevoir les axes, dépassant des deux côtés des manchons, des manchons montés sur les axes, A étant soumise à la relation L < A ≤ 1, et
- les fixations (H) étant supportées doublement en translation dans la direction longitudinale du dispositif.

2. Dispositif selon la revendication 1, **caractérisé en ce que**
- le dispositif de transport (T) comprend à chaque fois deux bras de transport disposés parallèlement l'un à l'autre,
- les bras de transport sont supportés de telle sorte qu'ils soient déplaçables dans la direction longitudinale, et
- sur chacun des bras de transport est disposée une fixation (H) déplaçable le long des bras de transport.

3. Dispositif selon la revendication 2, **caractérisé en ce que** le dispositif de transport (T) est en outre supporté de manière déplaçable dans la direction verticale.

4. Dispositif selon l'une quelconque des revendications 1 à 3, **caractérisé en ce que** les bras de transport peuvent recevoir les axes à chaque fois à proximité de leurs extrémités.

5. Dispositif selon l'une quelconque des revendications 1 à 4, **caractérisé en ce que** le dispositif comprend en outre une unité d'exposition (I) disposée avant l'unité de rinçage (II), dans laquelle des manchons photopolymérisables peuvent être exposés avec un rayonnement actinique sous forme d'images, et dans lequel l'unité d'exposition (I) présente également un dispositif de transport (T).

6. Dispositif selon l'une quelconque des revendications 1 à 5, **caractérisé en ce que** l'unité de rinçage (II) est une unité de rinçage (IIa) qui comprend deux brosses de rinçage (B1) et (B2) tournant en sens inverses, qui sont disposées en dessous du manchon, à condition que les vitesses de rotation du manchon et des deux brosses (B1) et (B2) puissent être régulées à chaque fois séparément les unes des autres.

7. Dispositif selon la revendication 6, **caractérisé en ce que** les brosses de rinçage (B1) et (B2) peuvent être déplacées dans la direction verticale au moyen d'un dispositif approprié, de sorte qu'elles puissent être déplacées d'une position de repos dans laquelle les brosses n'ont aucun contact avec le manchon dans la position de travail, dans laquelle les brosses sont en contact avec le manchon.

8. Dispositif selon l'une quelconque des revendications 6 ou 7, **caractérisé en ce que** les brosses de rinçage (B1) et (B2) sont à chaque fois munies d'au moins une racle pour enlever l'agent de rinçage en excès et/ou pour enlever les impuretés de la brosse.

9. Dispositif selon l'une quelconque des revendications 6 à 8, **caractérisé en ce qu'**en dessous des brosses de rinçage (B1) et (B2) est disposée une cuve ouverte vers le haut pour recevoir l'agent de rinçage, les brosses plongeant dans l'agent de rinçage par leur côté inférieur.

10. Dispositif selon la revendication 9, **caractérisé en ce que** l'unité de rinçage est munie d'un circuit d'agent de rinçage au moyen duquel de l'agent de rinçage est prélevé en continu de la cuve et à nouveau réintroduit dans la cuve, et dans lequel le circuit comprend une unité de mesure pour contrôler la teneur en matières solides dans l'agent de rinçage.

11. Procédé de fabrication de manchons pour impression flexographique à partir de manchons photopolymérisables, comprenant au moins une douille cylindrique ainsi qu'une couche photopolymérisable appliquée sur celle-ci, comprenant au moins les étapes de traitement suivantes :
(1) exposition sous forme d'images de la couche photopolymérisable au moyen d'un rayonnement actinique,
(2) élimination des parties non exposées des manchons exposés sous forme d'images à l'aide d'agents de rinçage,
(3) séchage des manchons rincés, et
(4) post-exposition des manchons avec un rayonnement UV,
**caractérisé en ce que** l'on met en oeuvre au moins les étapes de procédé (2), (3) et (4) dans un dispositif selon l'une quelconque des revendications 1 à 10.

12. Procédé selon la revendication 11, **caractérisé en ce qu'**il s'agit d'un dispositif selon l'une quelconque des revendications 4 à 10, et l'on met en oeuvre également l'étape de procédé (1) dans le dispositif.

13. Procédé selon la revendication 11 ou 12, **caractérisé en ce qu'**il s'agit d'un dispositif comprenant une unité de rinçage (IIa) avec deux brosses de rinçage (B1) et (B2) tournant en sens inverse l'une par rapport à l'autre selon l'une quelconque des revendications 6 à 10, (B1) tournant dans le même sens que le manchon et (B2) tournant en sens inverse du manchon, et dans lequel pour les vitesses de surface du manchon v_{S}, de la brosse (B1) v_{B1} ainsi que de la brosse (B2) v_{B2}, on a la relation suivante |v_{B2}| > |v_{S}| > |v_{B1}|>0.

14. Procédé selon la revendication 13, **caractérisé en ce que** la vitesse de rotation des brosses est ajustée de telle sorte que la différence des valeurs absolues des vitesses de surface entre le manchon et (B1), respectivement (B2), soit à chaque fois approximativement identique.
